Europäisches Patentamt

European Patent Office

Office européen des brevets

(19)

(11) Veröffentlichungsnummer: **0 029 962**
**B1**

(12) # EUROPÄISCHE PATENTSCHRIFT

(45) Veröffentlichungstag der Patentschrift:
**20.07.83**

(21) Anmeldenummer: **80107199.4**

(22) Anmeldetag: **19.11.80**

(51) Int. Cl.³: **C 23 C 11/00,** H 01 B 12/00,
H 01 B 5/02, C 22 C 27/02

(54) **Verfahren zur kontinuierlichen Herstellung von Niob-Germanium-Schichten auf einem Trägerkörper.**

(30) Priorität: **04.12.79 DE 2948735**

(43) Veröffentlichungstag der Anmeldung:
**10.06.81 Patentblatt 81/23**

(45) Bekanntmachung des Hinweises auf die Patenterteilung:
**20.07.83 Patentblatt 83/29**

(84) Benannte Vertragsstaaten:
**CH FR GB LI**

(56) Entgegenhaltungen:
**US-A-4 128 121**
**US-A-4 129 166**
**US-A-4 129 167**

(73) Patentinhaber: **SIEMENS AKTIENGESELLSCHAFT,**
**Berlin und München Wittelsbacherplatz 2,**
**D-8000 München 2 (DE)**

(72) Erfinder: **Müller, Alfred, Dr., Fichtestrasse 25,**
**D-8520 Erlangen (DE)**

Verfahren zur kontinuierlichen Herstellung von Niob-Germanium-Schichten auf einem Trägerkörper

Die Erfindung bezieht sich auf ein Verfahren zur kontinuierlichen Herstellung von Schichten mit der intermetallischen supraleitenden A15-Phase Niob-Germanium ($Nb_3Ge$) durch Reduktion von gasförmigen Halogeniden der Elemente Niob und Germanium an einem erhitzten Trägerkörper mittels Wasserstoff, indem ein Gasgemisch mit dem reduzierenden Wasserstoff und den Niob- und Germaniumhalogeniden einem Reaktionsraum zugeführt wird, durch den der Trägerkörper gezogen wird. Ein solches Verfahren ist z.B. der Veröffentlichung „Journal of the Less-Common Metals", vol. 59 (1978), 35 bis 41 zu entnehmen.

Zur Herstellung der supraleitenden A15-Phase Niob-Germanium ($Nb_3Ge$) wird vielfach die CVD (Chemical Vapor Deposition)-Technik angewandt [„IEEE Transactions on Magnetics", vol. MAG-14, Nr. 5 (Sept. 1978), S. 608 bis 610 und vol. MAG-15, Nr. 1 (Jan. 1979), S. 516 bis 519]. Gemäss dieser Technik, die seit langem zur Herstellung der intermetallischen supraleitenden Verbindung Niob-Zinnmetallischen supraleitenden Verbindung Niob-Zinn ($Nb_3Sn$) angewandt wird („RCA Review, vol. XXV (Sept. 1964), S. 342 bis 365), lässt sich durch eine Reduktion von gasförmigen Niob- und Germaniumhalogeniden mittels Wasserstoff an einem erhitzten Trägerköper, beispielsweise aus Kupfer oder Stahl, die intermetallische A15-Phase Niob-Germanium ($Nb_3Ge$) abscheiden.

Bisher wurden nur Herstellungsverfahren von verhältnismässig kurzen Leiterstücken mit Längen nicht über 20 m bekannt (vgl. die genannte Literaturstelle „Journal of the Less-Common Metals"). Geht man jedoch mit diesem bekannten Verfahren zur Herstellung von langen Leiterstücken über, d.h. von Leitern mit einer Länge von 100 m und mehr, so stellt sich heraus, dass zwar Leiter mit verhältnismässig gering schwankenden Werten der Schichtstärken und der kristischen Temperatur, beispielsweise mit Abweichungen von einem Mittelwert, die unter 10% liegen, hergestellt werden können, dass jedoch die kritische Stromdichte mit zunehmender Leiterlänge stark abfällt und beispielsweise am Ende eines etwa 150 m langen Leiterbandes nur noch ein Viertel des am Leiteranfang vorhandenen Wertes hat. Diese Abnahme der kritischen Stromdichte kann auch bei sorgfältiger Präparation der Leiter nicht vernhindert werden, insbesondere auch nicht, wenn Germanium und Niob während einer Abscheidungsdauer von mehreren Stunden in gleichbleibendem Mengenfluss auf einem Trägerkörper abgeschieden werden, der mit einer konstanten Geschwindigkeit durch die Atmosphäre des entsprechenden Reaktionsgasgemisches gefördert und dabei auf konstanter Temperatur gehalten wird.

Aufgabe der vorliegenden Erfindung ist es, das bekannte Verfahren dahingehend zu verbessern, dass mit ihm kontinuierlich lange Leiter, d.h. Leiter mit über 100 m Länge, mit aus der Gasphase abgeschiedenen Schichten, welche die supraleitende A15-Phase $Nb_3Ge$ enthalten, hergestellt werden können, ohne dass ein starker Abfall der kritischen Stromdichte mit zunehmender Leiterlänge auftritt.

Diese Aufgabe wird erfindungsgemäss bei einem Verfahren der eingangs genannten Art dadurch gelöst, dass dem Gasgemisch mit dem reduzierenden Wasserstoff und den Niob- und Germaniumhalogeniden Wasserdampf in solch geringer Menge beigemischt wird, dass ein Wassergehalt der in dem Reaktionsraum befindlichen Atmosphäre zwischen 0,05 und 0,001 Vol.-% erhalten wird.

Die kritische Stromdichte der auf dem Trägerkörper abgeschiedenen Schicht, welche neben der supraleitenden intermetallischen A15-Phase $Nb_3Ge$ auch die tetragonale Phase $Nb_5Ge_3$ enthält, hängt entscheidend von dem Gefüge dieser zweiphasigen Schicht ab. Die Vorteile der erfindungsgemässen Ausbildung des eingangs genannten Verfahrens bestehen nun darin, dass der geringe Wasserzusatz zu der Reaktionsgasatmosphäre zur Abscheidung eines gleichbleibend feinkristallinen Gefüges führt. Durch den Zusatz der geringen Wassermengen wird offenbar die Bildung der für ein derartiges Gefüge erforderlichen Kristallisationskeime unterstützt und lässt sich die Gefügeform stabilisieren.

Hierdurch wird eine gleichbleibend hohe Stromdichte auch bei grossen Leiterlängen gewährleistet.

Vorteilhafte Weiterbildungen des Verfahrens nach der Erfindung gehen aus den Unteransprüchen hervor.

Die Erfindung wird nachfolgend anhand der Zeichnung noch weiter erläutert. Dabei ist in der Zeichnung schematisch eine Apparatur zum Beschichten von Trägerkörpern grosser Länge mit der supraleitenden A15-Phase $Nb_3Ge$ nach dem Verfahren gemäss der Erfindung angedeutet.

Die zur Herstellung dieser Supraleiter erforderliche Apparatur kann in grossen Teilen einer in der CVD-Technik allgemein üblichen Apparatur entsprechen, mit welcher das $Nb_3Ge$ nach einer bekannten chemischen Reaktion erhalten wird.

Zum Transport des für die Reaktion erforderlichen Germaniumtetrachlorids ($GeCl_4$) dient ein Strom 2 von Argon als Trägergas. Das Argon ist mit dem $GeCl_4$ gesättigt. Hierzu strömt es durch ein Bad 3 mit flüssigem $GeCl_4$, das mittels einer Thermostateinrichtung 4 auf konstanter Temperatur in einem Bereich zwischen $-10$ und $+25°$ C gehalten wird. Neben der konstanten Temperatur des Bades muss ausserdem die Sättigung des Trägergases Argon gewährleistet sein.

Da sich für den Beschichtungsvorgang Niobpentachlorid ($NbCl_5$) in ähnlicher Weise nicht bereitstellen lässt, ist eine Chlorierung von festem Niobgranulat 5 bei einer hohen Temperatur von beispielsweise 920° C vorgesehen. Hierzu strömt ein Chlorgasstrom 6 mit Argon als Trägergas durch einen mit dem Niobgranulat 5 gefüllten Behälter und wird dort vollständig umgesetzt. Die Zusammensetzung des Reaktionsproduktes, die sich aus dem Verbrauch von Niob und Chlor ermitteln lässt, entspricht dann der Formel $NbCl_4$. Durch eine zusätzliche Chlorierung kann dann das stabile, leichtflüchtige Pentachlorid des Niobs erhalten werden. Hierzu ist eine Mischkammer 7 vorgesehen, die dem das Niobgranulat 5 enthaltenden Behälter nachgeordnet ist. In dieser Kammer wird das $NbCl_4$ einem weiteren Chlorgasstrom 8 ausgesetzt, wobei ein restloser Umsatz des Chlorgases gewährleistet sein muss.

In diese Mischkammer 7 wird ausserdem der mit $GeCl_4$ gesättigte und mit 9 bezeichnete Argonstrom eingeleitet.

Dem aus der Mischkammer 7 ausgeleiteten Gasstrom 11 aus dem Gasgemisch Ar, $NbCl_5$ und $GeCl_4$ wird anschliessend ein Gasstrom 12 aus Wasserstoff ($H_2$) mit Ar als Trägergas beigemischt. Dem sich so aus $NbCl_5$, $GeCl_4$, $H_2$ und Ar zusammengesetzten Gasstrom 13 werden ausserdem gemäss der Erfindung geringe Mengen von Wasser zugemischt. Hierzu dient ein weiterer Argonstrom 14, der einer Kammer 15 zugeführt und dort mit Wasserdampf versetzt wird. Der mit Wasserdampf gesättigte Argonstrom 16 wird anschliessend mit dem Gasstrom 13 vereinigt und als Reaktionsgasstrom 17 einer Beschichtungsvorrichtung 18 zugeführt. Auf dem Weg zu der Beschichtungsvorrichtung 18 wird dabei das Reaktionsgasgemisch auf eine Temperatur $T_1$ aufgeheizt, beispielsweise auf etwa 550° C. Eine Reaktion zwischen den Bestandteilen des Reaktionsgasgemisches ist dabei während der kurzen Zeit aufgrund einer verhältnismässig hohen Strömungsgeschwindigkeit nicht zu befürchten.

Die Beschichtungsvorrichtung 18 enthält einen langgestreckten Reaktionsraum 19, durch den ein zu beschichtender draht- oder bandförmiger Trägerkörper 20 grosser Länge von insbesondere über 100 m mit einer vorbestimmten Geschwindigkeit v hindurchgezogen werden kann. Als Trägerkörper 20 kann beispielsweise ein Band aus dem unter dem Handelsnamen Hastelloy B bekannten Material (Nickel, hauptsächlich legiert mit Mo, Co und Fe) oder ein Stahlband vorgesehen sein.

Der Trägerkörper 20 wird durch Öffnungen 23 bzw. 24 von Schleusen 21 und 22, die sich an den gegenüberliegenden Stirnseiten des Reaktionsraumes 19 befinden, in diesen hinein- bzw. aus diesem wieder herausgeführt.

Das sich durch den Reaktionsraum 19 erstreckende Teilstück des Trägerkörpers 20 muss auf eine vorbestimmte Temperatur $T_2$ von beispielsweise 900° C erhitzt werden. Das Erhitzen kann zweckmässig durch Stromdurchgang erfolgen. Hierzu sind ausserhalb der Beschichtungsvorrichtung 18 angeordnete Kontaktelemente 25 und 26, beispielsweise rollenförmige Graphitkontakte, vorgesehen, über die ein entsprechender Strom auf dieses Teilstück zu übertragen ist.

Der auf die Temperatur $T_1$ vorerhitzte und in den Reaktionsraum 19 eingeleitete Gasstrom 17 des Reaktionsgasgemisches durchströmt diesen Raum mit einer verhältnismässig hohen Strömungsgeschwindigkeit von beispielsweise 5 bis 13 m/s$^{-1}$. Dabei kann das Reaktionsgasgemisch allein durch den auf die Temperatur $T_2$ erhitzten Trägerkörper 20 nicht ausreichend für die gewünschte Reaktion aufgeheizt werden. Deshalb muss der Reaktionsraum 19 zusätzlich noch von aussen auf eine Temperatur $T_3$ von beispielsweise 700° C erwärmt werden. Hierzu dient mindestens ein Ofen 28, der den Reaktionsraum 19 umschliesst.

Der Reaktionsraum 19 der Beschichtungsvorrichtung 18 ist gegen die Atmosphäre nicht völlig abgeschlossen, sondern ist über die beiden Schleusen 21 und 22 zur Ein- bzw. Ausführung des Trägerkörpers 20 in bzw. aus dem Reaktionsraum 19 und über eine Abgasleitung 29 geöffnet.

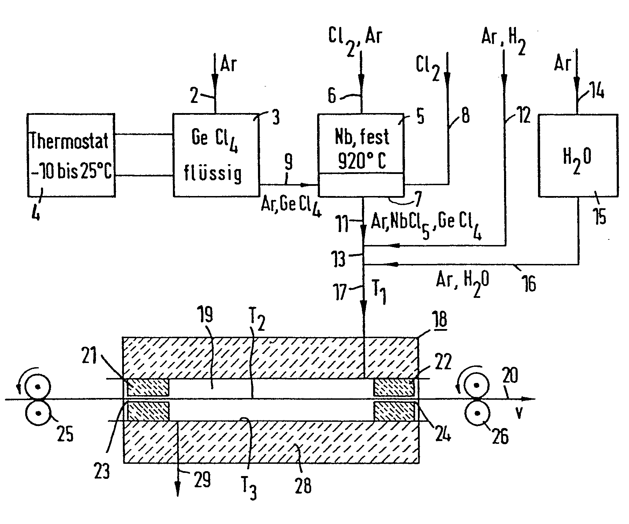

Die Abmessungen der Querschnitte in der in Fig. 1 angedeuteten Apparatur sind den gewünschten Strömungsgeschwindigkeiten und dem Durchsatz der jeweiligen Ausgangsstoffe angepasst. Dabei machen in einem Gasfluss des Reaktionsgases von beispielsweise 20 bis 50 mol/h$^{-1}$ die Metallchloride ungefähr 1 mol-% aus; knapp 40% davon tragen zur Beschichtung bei.

Die Konzentration des dem Gasgemisch 13 gemäss der Erfindung zugemischten Wassers soll zwischen 0,05 und 0,001 Vol.-% liegen. Vorzugsweise liegt sie zwischen 0,003 und 0,03 Vol.-%, bezogen auf das Reaktionsgasgemisch, bzw. zwischen 0,3 und 3 mol-%, bezogen auf die Summe der Metallchloride im Reaktionsgasgemisch. Bereits mit einer solch geringen Konzentration lässt sich dann erreichen, dass die kritische Stromdichte der auf dem Trägerkörper 20 abgeschiedenen intermetallischen Verbindung $Nb_3Ge$ über grosse Leiterlängen annähernd konstant bleibt. Ein entsprechendes Ausführungsbeispiel ist nach folgend beschrieben. Dabei wird auf die Herstellung und die Eigenschaften von zwei supraleitenden $Nb_3Ge$-Bandleitern eingegangen, wobei sich die verwendeten Reaktionsgase lediglich durch ihren Wassergehalt unterscheiden.

Die Herstellung der Bandleiter kann mit einer aus Quarzglas gefertigten, aus der CVD-Technik bekannten Apparatur erfolgen. Die Länge des Reaktionsraumes 19 beträgt etwa 75 cm, dessen Querschnitt 0,85 cm². Gasein- und Gasauslass sind an dessen gegenüberliegenden Enden vorgesehen. Ebenfalls an diesen Enden befinden sich die Schleusen 21 und 22, deren Öffnungen 23 bzw. 24 den Abmessungen des durch sie hindurchzuführenden, zu beschichtenden Trägerkörpers 20 angepasst sind. Als Schleusen können mit Edelgas gespülte Kammern verwendet werden, die mit Graphit verschlossen sind. Es können auch wassergekühlte Messingzylinder mit den Abmessungen des Trägerkörpers angepassten Öffnungen vorgesehen werden. Die Apparatur wird mit mehreren widerstandsbeheizten Öfen 28 in verschiedenen Abschnitten aufgeheizt.

Gemäss den Ausführungsbeispielen wird als Reaktionsgas ein Gemisch aus Ar, $H_2$, $NbCl_5$ und $GeCl_4$ folgender Durchsätze verwendet: Ar: 5.31 mol/h; $H_2$: 16,85 mol/h; $NbCl_5$: 0,145 mol/ h und $GeCl_4$: 0,53 mol/h. Das Gasgemisch erreicht den Reaktionsraum 19 mit einer Temperatur $T_1$ von etwa 450°C und durchströmt diesen mit einer Geschwindigkeit von etwa 5 m/s. Bei dem ersten Leiter A wird der Wassergehalt des Gemisches nicht kontrolliert und ist ohne zusätzliche Befeuchtung kleiner als 0,001 Vol.-%. Bei dem zweiten Leiter B wird das Reaktionsgas in einfacher Weise mittels eines wasserdampfgesättigten Argonstroms befeuchtet. Der zusätzliche Wasser durchsatz beträgt im Ausführungsbeispiel 0,66 mmol/h.

Als zu beschichtender Trägerkörper 20 ist jeweils ein Hastelloy-Band vorgesehen, das 2 mm breit und 50 µm stark ist. Das Band wird mit einer Geschwindigkeit v von 30 cm/min durch den Reaktionsraum 19 hindurchgezogen und mit elektrischem Strom auf eine Temperatur $T_2$ von etwa 860°C aufgeheizt.

Die folgende Tabelle enthält Messwerte der beiden Bandleiter A und B, die gemäss den vorstehenden Ausführungen in einer Länge von 145 m hergestellt sind, ohne bzw. mit zusätzlicher Befeuchtung des Reaktionsgases unter sonst gleichen Bedingungen. Die Messstellen sind dabei durch die Entfernung vom jeweiligen Leiteranfang gekennzeichnet. Angegeben sind in Abhängigkeit von der Lage der Messstellen die Daten für die kritische Temperatur $T_{c,0,5}$ bei Mitte des Übergangs vom supraleitunden in den normalleitenden Zustand und für die kritische Stromdichte $J_{c,5T}$ der Niob-Germanium-Schichten bei einer magnetischen Induktion von 5 T und einer Temperatur von 4,2 K.

**Tabelle**

| Messstelle | Leiter A | | Leiter B | |
|---|---|---|---|---|
| | $T_{c,0,5}$ | $J_{c,5T}$ | $T_{c,0,5}$ | $J_{c,5T}$ |
| [m] | [K] | [$10^5 Acm^{-2}$] | [K] | [$10^5 Acm^{-2}$] |
| 2 | 19,9 | 5,7 | 20,7 | 4,9 |
| 19 | 19,9 | 3,3 | 20,6 | 5,0 |
| 36 | 19,0 | 2,9 | 20,5 | 4,8 |
| 54 | 18,2 | 2,7 | 19,7 | 4,4 |
| 71 | 18,0 | 2,4 | 20,6 | 5,0 |
| 88 | 16,0 | 1,1 | 20,2 | 4,8 |
| 105 | 16,7 | 1,8 | 20,1 | 4,8 |
| 122 | 16,3 | 2,0 | 20,1 | 4,8 |
| 145 | 16,6 | 1,6 | 20,5 | 4,9 |
| Mittelwert | 17,8 | 2,6 | 20,3 | 4,8 |
| Mittlere Abweichung (%) | 1,5 (8,5) | 1,4 (51,5) | 0,3 (1,6) | 0,2 (3,7) |

Aus der Tabelle ist ersichtlich, dass eine wesentliche Abnahme der kritischen Stromdichte mit zunehmender Leiterlänge bei dem nach dem Verfahren gemäss der Erfindung beschichteten Leiter B im Gegensatz zum Leiter A nicht auftritt.

Gemäss dem Ausführungsbeispiel nach der Figur wurde eine Beimischung von Wasserdampf in ein Gasgemisch mit den Niob- und Germaniumhalogeniden und dem Wasserstoffgas vor einem Eintritt in den Reaktionsraum 19 vorgesehen. Ebensogut kann aber auch die Beimischung erst direkt in dem Reaktionsraum erfolgen.

Dem Ausführungsbeispiel wurde ferner die Bildung der supraleitenden intermetallischen Verbindung $Nb_3Ge$ aus speziellen Chloriden des Niobs und Germaniums zugrundegelegt. Man kann jedoch auch von anderen, aus der CVD-Technik bekannten Halogeniden dieser Elemente ausgehen.

**Patentansprüche**

1. Verfahren zur kontinuierlichen Herstellung von Schichten mit der intermetallischen supraleitenden A15-Phase Niob-Germanium ($Nb_3Ge$) durch Reduktion von gasförmigen Halogeniden der Elemente Niob und Germanium an einem erhitzten Trägerkörper mittels Wasserstoff, indem ein Gasgemisch mit dem reduzierenden Wasserstoff und den Niob- und Germaniumhalogeniden einem Reaktionsraum zugeführt wird, durch den der Trägerkörper gezogen wird, dadurch gekennzeichnet, dass dem Gasgemisch mit dem reduzierenden Wasserstoff und den Niob- und Germaniumhalogeniden Wasserdampf in solch geringer Menge beigemischt wird, dass ein Wassergehalt der in dem Reaktionsraum (19) befindlichen Atmosphäre zwischen 0,05 und 0,001 Vol.-% erhalten wird.

2. Verfahren nach Anspruch 1, gekennzeichnet durch eine Atmosphäre, mit einem Wassergehalt zwischen 0,03 und 0,003 Vol.-%.

3. Verfahren nach linem der beiden Ansprüche 1 oder 2, dadurch gekennzeichnet, dass ein mit Wasserdampf gesättigter Argonstrom (16) beigemischt wird.

4. Verfahren nach Anspruch 3, dadurch gekennzeichnet, dass der mit dem Wasserdampf gesättigte Argonstrom (16) dem den reduzierenden Wasserstoff und die Niob- und Germaniumhalogenide enthaltenden Gasstrom (13) ausserhalb des Reaktionsraumes (19) beigemischt wird und dass der so erhaltende Reaktionsgasstrom (17) dann in den Reaktionsraum (19) eingeleitet wird.

5. Verfahren nach einem der Ansprüche 1 bis 3, dadurch gekennzeichnet, dass der Wasserdampf dem Reaktionsraum (19) direkt zugeleitet wird.

6. Verfahren nach Anspruch 4, dadurch gekennzeichnet, dass das den reduzierenden Wasserstoff, die Niob- und Germaniumhalogenide und den Wasserdampf enthaltende Reaktionsgasgemisch (17) vor seiner Einleitung in den Reaktionsraum (19) vorerhitzt wird.

7. Verfahren nach einem der Ansprüche 1 bis 6, dadurch gekennzeichnet, dass die in dem Reaktionsraum (19) befindliche Atmosphäre mittels mindestens einer um den Reaktionsraum (19) angeordneten Heizvorrichtung (28) erhitzt wird.

8. Verfahren nach einem der Ansprüche 1 bis 7, dadurch gekennzeichnet, dass zumindest das sich in dem Reaktionsraum (19) befindliche Teilstück des Trägerkörpers (20) mittels Stromdurchgang erhitzt wird.

**Revendications**

1. Procédé de préparation en continu de couches ayant la phase supraconductrice intermétalli- que A15 niobium-germanium ($Nb_3Ge$), par réduction d'halogénures gazeux des éléments niobium et germanium sur un corps-support chauffé au moyen d'hydrogène, en envoyant un mélange gazeux contenant l'hydrogène réducteur et les halogénures de niobium et de germanium dans une chambre de réaction à travers laquelle le corps-support est tiré, caractérisé en ce qu'il consiste à ajouter au mélange gazeux, contenant l'hydrogène réducteur et les halogénures de niobium et de germanium, de la vapeur d'eau en une quantité si petite que la teneur en eau de l'atmosphère régnant dans la chambre de réaction (19) soit maintenue entre 0,05 et 0,001% en volume.

2. Procédé suivant la revendication 1, caractérisé par une atmosphère ayant une teneur en eau comprise entre 0,03 et 0,003% en volume.

3. Procédé suivant l'une des revendications 1 ou 2, caractérisé en ce qu'il consiste à effectuer l'addition d'un courant d'argon (16) saturé de vapeur d'eau.

4. Procédé suivant la revendication 3, caractérisé en ce qu'il consiste à ajouter, en dehors de la chambre de réaction (19), au courant gazeux (13), contenant l'hydrogène réducteur et les halogénures de niobium et de germanium, un courant d'argon (16) saturé par de la vapeur d'eau et à envoyer ensuite le courant gazeux de réaction (17) ainsi obtenu dans la chambre de réaction (19).

5. Procédé suivant l'une des revendications 1 à 3, caractérisé en ce qu'il consiste à envoyer directement la vapeur d'eau dans la chambre de réaction (19).

6. Procédé suivant la revendication 4, caractérisé en ce qu'il consiste à préchauffer le mélange gazeux de réaction (17) contenant l'hydrogène réducteur et les halogénures de niobium et de germanium et la vapeur d'eau avant son envoi dans la chambre de réaction (19).

7. Procédé suivant l'une des revendications 1 à 6, caractérisé en ce qu'il consiste à réchauffer l'atmosphère régnant dans la chambre de réaction (19) au moyen d'au moins un dispositif de chauffage (28) disposé autour de la chambre de réaction (19).

8. Procédé suivant l'une des revendications 1 à 7, caractérisé en ce qu'il consiste à réchauffer, au moyen d'un passage de courant électrique, au moins le tronçon du corps-support (20) se trouvant dans la chambre de réaction (19).

**Patent claims**

1. A process for the continuous production of layers of the intermetallic superconductive A15-phase niobium-germanium ($Nb_3Ge$) by reducing gaseous halides of the elements niobium and germanium at a heated carrier body by means of hydrogen, in which a gas mixture comprising the reducing hydrogene and the niobium and germanium halides is fed to a reaction space through which the carrier body is drawn, characterised in that water vapour is added to the gas mixture comprising the reducing hydrogen and the niobium and germanium halides in such a small amount that a water content of the atmosphere present in the reaction space (19) of between 0.05 and 0.001 vol.% is obtained.

2. A process as claimed in claim 1, characterised by an atmosphere having a water content of between 0.03 and 0.003 vol.%.

3. A process as claimed in claim 1 or 2, characterised in that a stream of argon (16) saturated with water vapour is added.

4. A process as claimed in claim 3, characterised in that the argon stream (16), which is saturated with water vapour, is added to the gas stream (13) which contains the reducing hydrogen and the niobium and germanium halides outside the reaction space (19), and that the reaction gas stream (17) so obtained is then introduced into the reaction space (19).

5. A process as claimed in one of claims 1 to 3, characterised in that the water vapour is directly fed to the reaction space (19).

6. A process as claimed in claim 4, characterised in that prior to its introduction into the raction space (19) the reaction gas mixture (17), containing the reducing hydrogen, the niobium and germanium halides and the water vapour, is preheated.

7. A process as claimed in one of claims 1 to 6, characterised in that the atmosphere present in the reaction space (19) is heated by means of at least one heating device (28) arranged around the reaction space (19).

8. A process as claimed in one of claims 1 to 7, characterised in that at least the part of the carrier body (20) which is present in the reaction space (19) is heated by the passage of current therethrough.